(19) Europäisches Patentamt / European Patent Office / Office européen des brevets

(11) **EP 4 571 335 B1**

(12) **EUROPEAN PATENT SPECIFICATION**

(45) Date of publication and mention
of the grant of the patent:
**06.05.2026  Bulletin 2026/19**

(21) Application number: **23216272.7**

(22) Date of filing: **13.12.2023**

(51) International Patent Classification (IPC):
**G01R 31/367** (2019.01)        **G01R 31/374** (2019.01)
**G01R 31/392** (2019.01)        **G01R 31/64** (2020.01)

(52) Cooperative Patent Classification (CPC):
**G01R 31/392; G01R 31/367; G01R 31/374;**
**G01R 31/64**

(54) **METHOD FOR DETERMINING A REMAINING LIFETIME OF AN ENERGY STORAGE UNIT; ENERGY STORAGE MANAGEMENT DEVICE; AND SYSTEM**

VERFAHREN ZUR BESTIMMUNG EINER RESTLEBENSDAUER EINER ENERGIESPEICHEREINHEIT, ENERGIESPEICHERVERWALTUNGSVORRICHTUNG UND SYSTEM

PROCÉDÉ DE DÉTERMINATION D'UNE DURÉE DE VIE RESTANTE D'UNE UNITÉ DE STOCKAGE D'ÉNERGIE, DISPOSITIF DE GESTION DE STOCKAGE D'ÉNERGIE ET SYSTÈME

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(43) Date of publication of application:
**18.06.2025  Bulletin 2025/25**

(73) Proprietor: **Skeleton Technologies GmbH**
**04420 Markranstädt (DE)**

(72) Inventors:
• **Schemel, Bertram**
**12205 Berlin (DE)**
• **Türke, Florian**
**13351 Berlin (DE)**

(74) Representative: **Hoffmann Eitle**
**Patent- und Rechtsanwälte PartmbB**
**Arabellastraße 30**
**81925 München (DE)**

(56) References cited:
**US-A1- 2023 278 463**

• **MESBAHI TEDJANI ET AL: "Advanced Model of Hybrid Energy Storage System Integrating Lithium-Ion Battery and Supercapacitor for Electric Vehicle Applications", IEEE TRANSACTIONS ON INDUSTRIAL ELECTRONICS, IEEE SERVICE CENTER, PISCATAWAY, NJ, USA, vol. 68, no. 5, 15 April 2020 (2020-04-15), pages 3962 - 3972, XP011836567, ISSN: 0278-0046, [retrieved on 20210208], DOI: 10.1109/TIE.2020.2984426**

**Description**

TECHNICAL FIELD

The present disclosure relates to a method for determining a remaining lifetime of an energy storage unit, and to a corresponding energy storage management device and system.

BACKGROUND

An energy storage unit is an electronic piece of equipment that stores energy produced at one time for use at a later time. As an example, energy can be stored in various forms such as a chemical and/or an electrical potential. In this manner, the energy storage unit may help in accommodate a discrepancy between a demand for the energy and a production of the energy. As an example, energy storage units play an increasingly crucial role in modern energy grid systems by compensating an offset between peaks in production by renewable energy sources, such as wind and solar, and periods of high demand. Further examples in which energy storage units find application includes mobile devices such as laptops and smartphones, electric vehicles such as electric cars and drones, IoT (internet of things) devices such as sensors and smart home devices, medical devices such as pacemakers and hearing aids, and the like.

Examples for an energy storage unit include a battery, a capacitor, and the like. Capacitors are used in various applications requiring many rapid charge and discharge cycles. As an example, capacitors may be used in automobiles, buses, trucks, trains, ships, industrial robots, cranes, elevators, and the like, where they are used for regenerative braking, short-term energy storage, or burst-mode power delivery. As another example, capacitors may be mounted on printed circuit boards where they may be used to absorb spikes in power delivered to an electronic component, thereby creating a constant steady stream of electricity required to power the electronic component. The properties of capacitors allow them to accept and deliver electric charge much faster compared to batteries, and to tolerate many more charge and discharge cycles compared to rechargeable batteries.

Over time, as the energy storage unit ages, its ability to store energy may degrade. Typically, a degree of this degradation is indicated by a state of health, SoH, of the energy storage unit. The SoH describes a present ability to store energy as a percentage value with respect to a rated ability of the energy storage unit (e.g. as provided by a manufacturer). That means that the SoH has an initial value of 100% at the beginning of the lifetime of the energy storage unit (i.e. at the time of manufacture), and a final value of practically 0% at the end of the lifetime. Variability in manufacturing may cause the initial value to deviate from 100% to a certain extent (e.g. usually at the order to 5% or less). Typically, the end of the lifetime may be identified with a different value of the SoH greater than 0%. As an example, the end of the lifetime may be identified with a SoH value of 80% or even higher for performance-critical applications.

A common technique to estimate the SoH of an energy storage unit is the so-called Miner rule in which stress and/or fatigue damages caused during charge-discharge cycles of the energy storage unit are linearly accumulated.

US 2023/278463 A1 discloses that the health of a battery within an electric or hybrid electric vehicle may be estimated by receiving battery condition signals from a battery monitoring system within the vehicle. The received battery condition signals are used to estimate an SOH (state of health) of the battery and an SOC (state of charge) of the battery. The estimated SOH and the estimated SOC are used in combination with a degradation model to estimate one or more of a capacity loss-related parameter and a internal resistance-related parameter, which are then used to estimate a RUL (remaining useful life) value and/or a CBW (cumulative battery wear cost) value.

MESBAHI TEDJANI ET AL: "Advanced Model of Hybrid Energy Storage System Integrating Lithium-Ion Battery and Supercapacitor for Electric Vehicle Applications", IEEE TRANSACTIONS ON INDUSTRIAL ELECTRONICS, IEEE SERVICE CENTER, PISCATAWAY, NJ, USA, vol. 68, no. 5, 15 April 2020, pages 3962-3972, XP011836567 deals with the advanced electrothermal modeling of a hybrid energy storage system integrating lithium-ion batteries and supercapacitors. The objective is to allow the aging aspects of the components of this system to be taken into account. The development of a model including the electrothermal behaviors makes it possible to evaluate the progressive degradation of the performance of the hybrid energy storage system.

SUMMARY

However, the SoH is only able to indicate a remaining lifetime of the energy storage unit in relative terms. The remaining lifetime refers to an amount of time until the end of the lifetime of the energy storage unit. In other words, knowing the SoH may not be sufficient to predict, in absolute terms, at which point in time (e.g. a calendar date) the end of the lifetime will be reached.

Furthermore, even if a reference value of the lifetime is available (e.g. as provided by a manufacturer), an estimate for the remaining lifetime based on the SoH and this reference value may lack accuracy because (individual) operating conditions (e.g. usage conditions such as driver patterns and environmental conditions such as temperature) of the energy storage unit may fluctuate significantly while the energy storage unit is in use, thereby potentially causing a large deviation of an actual value of the lifetime from the reference value. Hence, there is a need for a reliable and accurate method for determining a remaining lifetime of an energy storage unit.

The invention is set out in the appended independent claims. Further preferred embodiments are defined in the dependent claims.

By estimating the SoC and the present value of the energy storage parameter and predicting the time evolution of the energy storage parameter based on present operating conditions (i.e. SoC and temperature) of the energy storage unit, it becomes possible to reliably and accurately determine a remaining lifetime of an energy storage unit. In this manner, for example, scheduling of maintenance can be optimized such as to prevent unplanned downtime or to reduce wasted resources that would otherwise occur when the energy storage unit is replaced too early (i.e. well ahead of the end of the lifetime).

BRIEF DESCRIPTION OF THE DRAWINGS

Fig. 1      shows flow chart for a method for determining a remaining lifetime of an energy storage unit according to an embodiment;

Fig. 2      shows a plot of a time evolution of a capacitance loss of an energy storage unit provided as a supercapacitor;

Fig. 3A     shows a two-dimensional hyperplane representing an example for the functional dependency of the aging factor on the SoC and temperature of the energy storage unit;

Fig. 3B     shows a table comprising the corresponding parameters and their associated values determined by the regression;

Fig. 4      show a schematic illustration of a hardware structure of an energy storage management device according to an embodiment; and

Fig. 5      shows a system according to an embodiment.

DETAILED DESCRIPTION

The present disclosure shall now be described in conjunction with specific embodiments. The specific embodiments serve to provide the skilled person with a better understanding but are not intended to in any way restrict the scope of the present disclosure, which is defined by the appended claims. In particular, the embodiments described independently throughout the description can be combined to form further embodiments to the extent that they are not mutually exclusive.

An energy storage unit according to an embodiment may be a battery. A battery typically comprises one or more electrochemical cells with external connections for supplying power to an electrical device connected thereto. Examples for batteries include alkaline batteries, lead-acid batteries, lithium-ion batteries, sodium-ion batteries, and the like. A rechargeable battery can be discharged and recharged multiple times using an applied electric current. Batteries are used in a variety of applications such as powering mobile devices (e.g. laptops, smartphones, and the like), powering electric vehicles, providing backup power for critical systems, and the like.

An energy storage unit according to an embodiment may be a supercapacitor. A synonymous expression is ultracapacitor. The term supercapacitor is preferably understood to extend to any capacitor that fulfills one or more of the following criteria: a) a maximum capacitance in excess of 10 F, preferably in excess of 100 F, more preferably in excess of 1000 F; b) a specific energy (expressed in watt-hours (Wh) per device weight in kilogram (kg)) in excess of 1 Wh/kg, preferably in excess of 5 Wh/kg, more preferably in excess of 10 Wh/kg. The supercapacitor may, for example, be an electrochemical double-layer capacitor which stores energy in an electric field of the electrochemical double-layer. The electrochemical double-layer capacitor may comprise two electrodes and an electrolyte, wherein the electrochemical double-layer is formed within the electrolyte on a surface of each of the electrodes when a voltage is applied to the electrodes. The electrodes may comprise porous conductive active materials such as activated carbon. The electrolyte may comprise a solvent and a salt.

A measure of the ability of an energy storage unit to store energy may be given by an energy storage parameter. The energy storage parameter may be indicative of a maximum amount of energy that can be stored and/or released by the energy storage unit. For a battery, the energy storage parameter may be the capacity (charge; with SI-units: Coulomb (C)) of the energy storage unit or may be based thereon. For a supercapacitor, the energy storage parameter may be the capacitance (units: Farad (F)) of the energy storage unit or may be based thereon. Alternatively, for a battery or a supercapacitor, the energy storage parameter may be the resistance or inductance (units: Ohm (Q)) of the energy storage unit or may be based thereon.

The energy storage parameters may indicate a present value of the ability of an energy storage unit to store energy relative to a reference value for this ability. The energy storage parameters as a fraction of or a difference from the reference value. As an example, the reference value may be provided by a manufacturer of the energy storage cell. Alternatively, the reference value may be determined by a measurement or estimate for the ability of an energy storage unit to store at the beginning of its lifetime.

Over time, as the energy storage unit is used, its ability to store energy may degrade. At the beginning of its lifetime, i.e. when the energy storage unit is new, i.e. when it has been manufactured, its ability to store energy may be indicated by an initial value of the energy storage parameter. Then, after having been used for a period of time, the ability to store energy may be reduced, and the reduced ability to store energy may be indicated by a present value of the energy storage parameter.

A manufacturer of the energy storage unit may provide information related to a rated value of energy storage parameter. Ideally, the initial value and the rated value of the energy storage parameter are identical. However, due to variability in the manufacturing process, the initial value and the rated value of the energy storage parameter may differ from each other to a certain extent (e.g. usually at the order to 5% or less).

The energy storage unit may be considered to have reached an end of its lifetime when its ability to store energy is reduced below a predetermined threshold. The end of the lifetime may also be referred to as the "end of life" (EOL). The end of the lifetime may be given in absolute terms, i.e. as a remaining number of days (or a point in time such as a calendar date and/or a time of day). In other words, the predetermined threshold may indicate an intended end of the lifetime of the energy storage unit.

The predetermined threshold may be determined based on an intended application of the energy storage unit. As an example, the intended application may be specified by a user of the energy storage unit. As an example, the intended application may be specified by a manufacturer of the energy storage unit. As an example, for performance-critical applications, the predetermined threshold may be relatively high, while for less demanding applications, the predetermined threshold may be relatively low. In other words, the lifetime of the energy storage unit may be based on the intended application of the energy storage unit. Therefore, the lifetime may also be referred to as the "useful lifetime" in order to indicate that it relates to a usefulness to the intended application.

The end of the lifetime may be indicative of a remaining lifetime. The remaining lifetime may indicate a period of time between now and the end of the lifetime. Alternatively, the remaining lifetime may indicate a period of time between a point in time at which the present value (i.e. the latest value or most up-to-date value) of the energy storage parameter has been determined and the end of the lifetime. As explained above, the remaining lifetime may also be referred to as a "remaining useful lifetime" (RUL).

Common techniques for estimating a lifetime of a battery or capacitor exhibit at least one of three inaccuracies. Examples for common techniques exhibiting at least one of the three inaccuracies include References [1] to [5].

One common technique which estimates a lifetime based on an averaged present value of an ability of the battery or capacitor to store energy may encounter, as a first inaccuracy, the issue that a present value of the ability of the battery or capacitor to store energy may deviate from said averaged present value, wherein the averaged present value is computed based on multiple test batteries or test capacitors. Typically, the averaged present value may be extracted from a lookup table.

Another common technique which estimates a lifetime based on an ability of the reference battery or reference capacitor to store energy, i.e. under specific reference operating conditions, may encounter, as a second inaccuracy, the issue that operating conditions in a real-world application may deviate from said reference operating conditions. Typically, reference operating condition refer to ideal operating conditions unlikely to be achieved in a real-world application.

Yet another common technique which estimates a lifetime based on an assumption of constant operating condition during the lifetime of the battery or capacitor to store energy may encounter, as a third inaccuracy, the issue that future operating conditions may deviate from the assumed constant operating conditions. However, operating conditions at the present point in time may deviate from operating conditions at a future point in time, resulting in a non-linear degradation of the ability of the battery or capacitor to store energy over time.

In order to properly determine for how long an energy storage unit can practically be used until it reaches the end of its lifetime, the remaining lifetime of the energy storage unit needs to be determined more accurately and reliably.

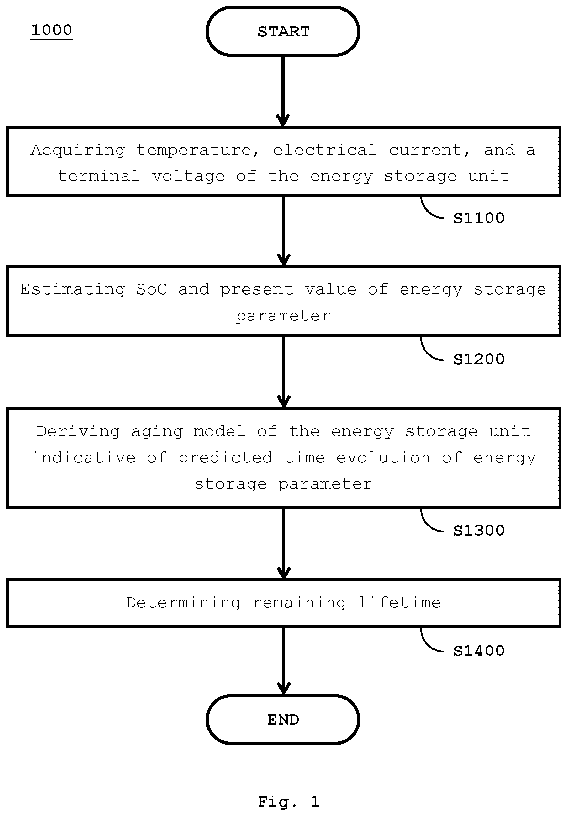

Fig. 1 shows a flowchart for a method for determining a remaining lifetime of an energy storage unit. The method 1000 is performed by a computer. The method 1000 comprises the steps S1100, S1200, S1300, and S1400.

The step S1100 includes acquiring a temperature of the energy storage unit, an electrical current supplied from or to the energy storage unit and a terminal voltage of the energy storage unit. The temperature has SI units of Kelvin (K), the electrical current has SI units of ampere (A), and the terminal voltage has SI units of volt (V). The temperature, the electrical current, and/or the terminal voltage may be associated with a corresponding uncertainty.

The temperature of the energy storage unit may refer to one of an ambient temperature of the energy storage unit, a surface temperature of an outer surface of the energy storage unit, an internal temperature of energy storage unit. The terminal voltage may be an open-circuit voltage (OCV) which refers to a difference in electrical potential between two terminals of the energy storage unit when disconnected from any circuit for a sufficient period of time. Alternatively, the terminal voltage may be a closed-circuit voltage (CCV) which refers to a difference in electrical potential between two terminals of the energy storage unit when connected to a circuit comprising a load and/or a power supply.

The temperature of the energy storage unit, the electrical current supplied from or to the energy storage unit, and the terminal voltage of the energy storage unit may be acquired based on information measured by corresponding measurement devices, i.e. a temperature sensor, a current sensor, and a voltage sensor, respectively. The temperature, the electrical current, and the terminal voltage may be acquired directly from the corresponding measurement devices (e.g. by receiving and processing the information therefrom via a data connection) or may be inputted by a user. The temperature, the electrical current, and the terminal voltage may be associated with a point in time at which the corresponding measurements by the measurement devices have been performed. As it may not be feasible to accurately synchronize the measurements, the point in time associated with the temperature, the electrical current, and the terminal voltage may correspond to one of or an average of the individual measurement times.

The step S1200 includes estimating a state of charge, SoC, and a present value of an energy storage parameter of the energy storage unit based on the temperature, the electrical current and the terminal voltage. The SoC refers to a present amount of (electric) charge stored by the energy storage unit relative to a maximum amount of charge that can be stored and/or released by the energy storage unit at the present time.

The SoC and the present value of an energy storage parameter may be estimated according to the technique disclosed in Reference [6]. Therein, a corrected SoC, which may correspond to the SoC estimated in step S1200, and a present value of the capacitance, which may correspond to the energy storage parameter estimated in step S1200, are estimated for a (super-) capacitor, which may correspond to the energy storage unit, using an internal state estimation algorithm such as a Kalman filter algorithm or a Lueneberger observer algorithm. For an energy storage unit provided as a battery, other common techniques may be used for estimating the SoC and the present value of the energy storage parameter (e.g. the (charge) capacity of the battery) based on the acquired temperature, electrical current and terminal voltage.

The temperature, the electrical current, and the terminal voltage may be continually acquired in a time-discrete manner, and the SoC and the present value of an energy storage parameter may be estimated in real time. In other words, the SoC and the present value of an energy storage parameter may be continually updated based on the latest acquired temperature, electrical current, and terminal voltage. In this manner, the above-described first inaccuracy is countered.

The step S1300 includes deriving an aging model of the energy storage unit based on the SoC and the temperature, wherein the aging model is indicative of a predicted time evolution of the energy storage parameter of the energy storage unit. In other words, the SoC and the temperature may be used to define a corresponding aging model.

The aging model may indicate a predicted value of the energy storage parameter as a function of time. The predicted time evolution (i.e. the shape of the curve described by the aging model) may vary depending on the SoC and the temperature of the energy storage unit. In other words, two aging models may be considered to be different from one another if they predict different time evolutions of the energy storage parameter due to different operating conditions (i.e. SoC and temperature) based on which the two aging models are derived. As an example, for a high estimated SoC (e.g. 90%), the aging model may be a first aging model may indicate a quicker aging process of the energy storage unit, whereas for a medium estimated SoC (e.g. 50%), the aging model may be a second aging model (different from the first aging model) and may indicate a slower aging process. As another example, for a higher temperature (e.g. 80°C), the aging model may be a third aging model and may indicate a quicker aging process, whereas for a lower temperature (e.g. 20°C), the aging model may be a fourth aging model (different from the third aging model) and may indicate a slower aging process. In this manner, the above-described second inaccuracy is countered.

The step S1400 includes determining the remaining lifetime based on the derived aging model, the present value of the energy storage parameter and an initial value of the energy storage parameter. The remaining lifetime may be determined by extrapolating (using the derived specific aging model) the energy storage parameter starting from the present value of the energy storage parameter and determining the end of the lifetime as the point in time at which a predicted (i.e. extrapolated) value of the energy storage parameter crosses the predetermined threshold. In this manner, the above-described third inaccuracy is countered.

The initial value of the energy storage parameter may be defined as the value of the energy storage parameter estimated at a point in time shortly after the beginning of lifetime of the energy storage unit (i.e. according to step S1100 and S1200), e.g. during its first use. After this point in time, a value of the energy storage parameter may change due to aging, but the initial value may be stored in a non-volatile memory and will remain constant. Alternatively, the initial value may be a predefined value such as an average initial value of the energy storage parameter across a plurality of reference energy storage units.

The following description with regard to determining the remaining lifetime based on the derived aging model, the present value of the energy storage parameter (i.e. according to step S1400) and the initial value of the energy storage parameter will be made for a supercapacitor, as the energy storage unit, and a capacitance loss, as the energy storage parameter. However, the following description can also be referred to, with the necessary adaptations, for other types of energy storage units and other definitions of the energy storage parameter. The skilled person will find that making the necessary amendments is straightforward.

As an example, instead of expressing the energy storage parameter as a capacitance loss, the energy storage parameter may be expressed as an increase in resistance or impedance, e.g. an increase in the internal cell resistance. The internal cell resistance may also be referred to as equivalent series resistance (ESR). As another example, instead of considering a supercapacitor as the energy storage unit, the energy storage unit may be provided by a battery. Then, instead of expressing the energy storage parameter as a capacitance loss, the energy storage parameter may be expressed as a capacity (charge) loss.

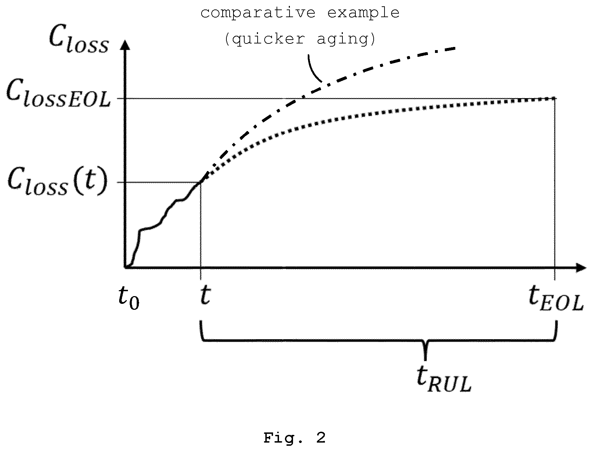

Fig. 2 shows a plot of a time evolution of a capacitance loss $C_{loss}$ of an energy storage unit provided as a supercapacitor. Here, the energy storage parameter is given by the capacitance loss $C_{loss}$ which refers to the amount of capacitance lost since a reference point in time $t_0$ (e.g. when the supercapacitor was manufactured). Between the reference point in time $t_0$ and the present point in time t, an estimated time evolution of the capacitance loss $C_{loss}$ has been estimated continually in real time (i.e. according to steps S1100 and S1200), as indicated by the solid curve. Between the present point in time t and the end of the lifetime $t_{EOL}$, a predicted time evolution of the capacitance loss $C_{loss}$ has been determined based on the derived aging model, the initial and the present value of the capacitance loss $C_{loss}(t)$ (i.e. according to steps S1300 and S1400), as indicated by the dashed curve. The end of the lifetime $t_{EOL}$ corresponds to the point in time at which a predicted value of the capacitance loss $C_{loss}$ crosses or reaches the predetermined threshold $C_{lossEOL}$. The remaining lifetime $t_{RUL}$ refers to the period of time between present point in time t and the end of the lifetime $t_{EOL}$.

The dashed-and-dotted curve in Fig. 2 refers to a comparative example of a different aging model. Compared to the above-described aging model indicated by the dashed curve the different aging model has a steeper gradient, thereby predicting a quicker aging process. The different aging model may correspond to a higher temperature and/or a higher SoC compared to the temperature and SoC on which the aging model indicated by the dashed curve is based on.

The aging model may be based on an aging factor a(SoC, T) having a functional dependency on the SoC and the temperature T of the energy storage unit. The aging model may be derived by evaluating the aging factor a(SoC, T) for the estimated SoC (i.e. according to steps S1100 and S1200) and acquired temperature (i.e. according to step S1100). The aging factor evaluated for the estimated SoC and acquired temperature may be a scalar value (e.g. a real-valued number). One aging model may be regarded as different from another aging model if their respective aging factors have different scalar values.

Acquiring the temperature, electrical current and terminal voltage, may be performed at multiple points in time. Furthermore, estimating the SoC may be performed for the multiple points in time. Then, the aging model may be derived based on the SoC and the temperature at one or more of the multiple points in time. In other words, the multiple points in time may form a time series. As an example, the electrical current may be acquired continually. The time period between each of the plurality of measurement times may be referred to as a measurement interval. As an example, the temperature, electrical current and terminal voltage may be acquired every 50 ms, i.e. at a polling rate of 20 Hz.

The aging model may be derived based on the SoC and the temperature at a present point in time of the multiple points in time, i.e. the latest point in time of the multiple points in time. In this manner, the aging model may be derived according to the latest (i.e. most up-to-date) operating conditions (i.e. SoC and temperature T).

Alternatively, the aging model may be derived based on an average SoC and an average temperature over two or more of the multiple points in time. In this manner, the aging model may be less susceptible to fluctuations in the operating conditions (i.e. SoC and temperature T). The average SoC and/or the average temperature may be taken over all of the multiple points in time. The average SoC and/or the average temperature may be taken over all of the multiple points in time except the one or more earliest points in time. The SoC and/or temperature at the one or more earliest points in time may be excluded in order to reduce a source of inaccuracy for the average SoC and/or the average temperature due to a different environmental and/or load condition at the earliest point in time. In other words, the average SoC and/or the average temperature may be taken over the one or more most recent points in time.

The aging model indicating a predicted capacitance loss $C_{loss}(\tau)$ as a function of the time $\tau$ may be represented by Equation 1. In other words, the predicted time evolution of the capacitance loss $C_{loss}(\tau)$ may follow a curve corresponding to the square-root of the time $\tau$, wherein the slope may additionally depend on the operating conditions of the super-capacitor.

$$C_{loss}(\tau) = a(SoC, T) \cdot \sqrt{\tau} \qquad \text{[Equation 1]}$$

The functional dependency of the aging factor a(SoC, T) may be quadratic in the SoC of the energy storage unit. The functional dependency of the aging factor a(SoC, T) on the temperature T of the energy storage unit may be based on an Arrhenius equation. As an example, the functional dependency of the aging factor a(SoC, T) may be described by Equation 2.

$$a(SoC, T) = (p \cdot SoC^2 + q \cdot SoC + r) \cdot A^{(T - T_{ref})/\Delta T} \qquad \text{[Equation 2]}$$

In other words, the functional dependency on SoC may be described a second-order polynomial with parameters p, q and r, and the functional dependency on temperature T may be described according to an Arrhenius equation with parameters A, $T_{ref}$ and $\Delta T$.

The parameters p, q, r, A, $T_{ref}$ and $\Delta T$ in the functional dependency may be determined by a regression based on a plurality of measurement points. The acquiring of the plurality of measurement points may preferably be performed in advance, for example, under laboratory conditions. The regression may preferably be performed in advance. The determined values of the p, q, r, A, $T_{ref}$ and $\Delta T$ may be stored in a non-volatile memory. In other words, values of the parameters may be determined such that a functional dependency of the aging factor best fits the plurality of measurements points. In this manner, the derived aging model is based on physically motivated fits to measurements associated with aging under real operating conditions. Each of the plurality of measurement points may be associated with an uncertainty and measurement points may be weighted based on their uncertainty when performing the regression.

Each of the plurality of measurement points may comprise a reference aging parameter associated with a given combination of SoC and temperature, wherein the reference aging parameter is derived based on a measured time evolution of the energy storage parameter of a corresponding reference energy storage unit. As an example, a reference aging factor may be determined for each of a plurality of reference energy storage units, wherein at least some of the reference storage units may be kept at different operating conditions (i.e. SoC and temperature T). For each of the reference energy storage unit, the reference aging factor may be determined by observing a time evolution of energy storage parameter and determining the reference aging factor such that a predicted time evolution of the energy storage parameters best fits the observed time evolution.

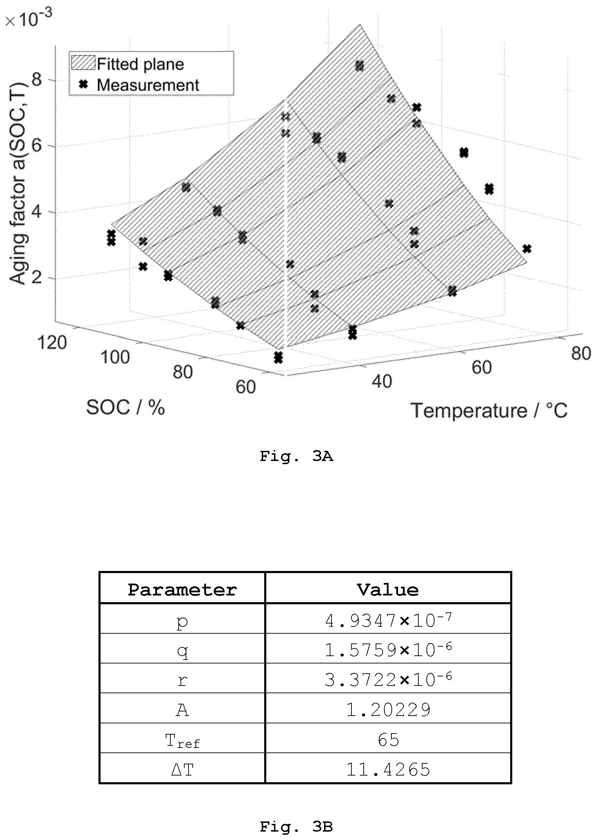

Fig. 3A shows a two-dimensional hyperplane representing an example for the functional dependency of the aging factor a(SoC, T) on the SoC and temperature of the energy storage unit (i.e. according to Equation 2). The cross markers (x) represent the plurality of measurement points. In order to derive an aging model (i.e. according to step S1200), a point on the two-dimensional hyperplane is selected that correspond to the estimated SoC (i.e. according to steps S1100 and S1200) and acquired temperature (i.e. according to step S1100). Fig. 3B shows a table comprising the corresponding parameters and their associated values determined by the regression.

Returning to the example discussed with reference to Equations 1 and 2, a predicted value of the capacitance loss $C_{loss}(t_{EOL})$ at the end of the lifetime $t_{EOL}$ may be determined by extrapolating the capacitance loss starting from the present value of the capacitance loss $C_{loss}(t)$ at the present point in time t using the aging model (i.e. according to Equation 1), as shown in Equation 3.

$$C_{loss}(t_{EOL}) = C_{loss}(t) + a(SoC_{RUL}, T_{RUL}) \cdot \left(\sqrt{t_{EOL}} - \sqrt{t}\right) \qquad \text{[Equation 3]}$$

Here, $a(SoC_{RUL}, T_{RUL})$ refers to the aging factors evaluated for the operating conditions $SoC_{RUL}$ and $T_{RUL}$. As explained above, the operating conditions $SoC_{RUL}$ and $T_{RUL}$ may be determined as the SoC and the temperature at a present point in time, or as the average SoC and average temperature over two or more of the multiple points in time.

The end of the lifetime $t_{EOL}$ may then be determined as the point in time at which $C_{loss}(t_{EOL})$ is equal to the predetermined threshold $C_{lossEOL}$, as shown in Equation 4.

$$C_{loss}(t_{EOL}) = C_{lossEOL} \qquad \text{[Equation 4]}$$

The capacitance loss $C_{loss}$ may be quantified in relative terms, i.e. as a percentage of the initial value $C_{init}$ of the capacitance of the supercapacitor, as shown in Equation 5 for an arbitrary point in time $\tau$. As an example, the capacitance loss $C_{loss}$ may be quantified by a unitless value between 0 and 1, or between 0% and 100%.

$$C_{loss}(\tau) = 1 - \frac{C(\tau)}{C_{init}} \qquad \text{[Equation 5]}$$

Here, $C(\tau)$ refers to the value of the capacitance at time $\tau$ (SI units: Farad (F)). In this case, the predetermined threshold $C_{lossEOL}$ may be defined as shown in Equation 6.

$$C_{lossEOL} = 1 - \gamma \cdot \frac{C_{rated}}{C_{init}} \qquad \text{[Equation 6]}$$

Here, the factor $\gamma$ is a real-valued number that refers to a fraction of the rated value of the capacitance $C_{rated}$ at or below which the supercapacitor is considered to have reached the end of its lifetime. As an example, the factor $\gamma$ may be set to 80% (i.e. 0.8) for performance-critical applications of the supercapacitor.

Then, solving Equation 3 for $t_{EOL}$ results in the expression given in Equation 7. The aging factor has SI units of time to the power of -1/2.

$$t_{EOL} = \left[ \frac{C_{loss}(t_{EOL}) - C_{loss}(t)}{a(SoC_{RUL}, T_{RUL})} + \sqrt{t} \right]^2$$

$$= \left[ \frac{1 - \gamma \cdot \frac{C_{rated}}{C_{init}} - 1 + \frac{C(t)}{C_{init}}}{a(SoC_{RUL}, T_{RUL})} + \sqrt{t} \right]^2$$

$$= \left[ \frac{C(t) - \gamma \cdot C_{rated}}{C_{init} \cdot a(SoC_{RUL}, T_{RUL})} + \sqrt{t} \right]^2 \qquad \text{[Equation 7]}$$

The initial value $C_{init}$ of the capacitance may be defined as the value of the capacitance estimated at a point in time shortly after the beginning of lifetime of the supercapacitor (i.e. according to step S1100 and S1200), e.g. during its first use. After this point in time, $C(\tau)$ may decrease due to aging, but $C_{init}$ may be stored in a non-volatile memory and will remain constant. Alternatively, the initial value $C_{init}$ may be a predefined value such as an average initial value of the capacitance across the plurality of reference energy storage unit (i.e. reference supercapacitors) used for determining the parameters in the functional dependency of the aging factor.

The end of the lifetime $t_{EOL}$ is indicative of the remaining lifetime $t_{RUL}$. In other words, the remaining lifetime (e.g. in days, hours, and/or minutes) may be computed as $t_{RUL} = t_{EOL} - t$, wherein t refers to the present point in time.

The method 1000 may further comprise the step of outputting, on a graphical user interface, the remaining lifetime of the energy storage unit. The graphical user interface may be a display coupled to the computer. As an example. the remaining lifetime may be outputted as the number of day, hours, and/or minutes until the end of the lifetime of the energy storage unit. As another example. the remaining lifetime may be outputted as a calendar date (and optionally also a time of day) of the end of the lifetime of the energy storage unit. In this manner, a user may be informed about the remaining lifetime.

Alternatively or in addition thereto, the method 1000 may further comprise the step of scheduling replacement of the energy storage unit based on the remaining lifetime. The scheduling of the replacement may be performed by automatically placing an order with a manufacturer or a vendor of energy storage units suitable to perform replacement close to the end of the remaining lifetime. The order may be placed via an API of a webstore, via an automatically generated email, or the like. In this manner, unplanned downtime can be prevented or wasted resources can be reduced that would otherwise occur when the energy storage unit is replaced too early (i.e. well ahead of the end of the lifetime).

Alternatively or in addition thereto, the method 1000 may further comprise the step of adjusting an electrical current supplied from or to the energy storage unit based on the remaining lifetime such that the SoC of the energy storage unit is within a target SoC range associated with a desired remaining lifetime. As an example, an electrical circuit connected to the energy storage unit may be controlled such that the energy storage unit is charged or discharged to a value of the SoC within the target SoC range. The target SoC range may be specified by a user of the energy storage unit. The user may specify the target SoC range based on an application of the energy storage unit. As an example, the user may specify the target SoC range to be between 45% and 55%.

Alternatively or in addition thereto, the method 1000 may further comprise the step of adjusting an electrical current supplied from or to the energy storage unit based on the remaining lifetime such that the temperature of the energy storage unit is within a target temperature range associated with a desired remaining lifetime. As an example, an electrical circuit connected to the energy storage unit may be controlled such as to reduce the amount of charge and discharge cycles of the energy storage unit, thereby reducing or increasing ohmic heating occurring within the energy storage unit, and reducing or increasing its temperature to be within the target temperature range. The target temperature range may be specified by a user of the energy storage unit. The user may specify the target temperature range based on an application of the energy storage unit. As an example, the user may specify the target temperature range to be between 20°C and 30°C.

Alternatively or in addition thereto, the method 1000 may further comprise the step of controlling a temperature regulation device to heat or cool the energy storage unit based on the remaining lifetime such that the temperature of the energy storage unit is within a target temperature range associated with a desired remaining lifetime. The temperature regulation device may be a fan, an air conditioner, a heater, a water-cooling system, or the like. The temperature regulation device may transfer heat to or away from the energy storage unit, thereby reducing or increasing its temperature to be within the target temperature range.

An energy storage management device may comprise a processor and a memory, the memory containing instructions executable by the processor, whereby the energy storage management is operative to carry out the method according to any of the embodiments disclosed above.

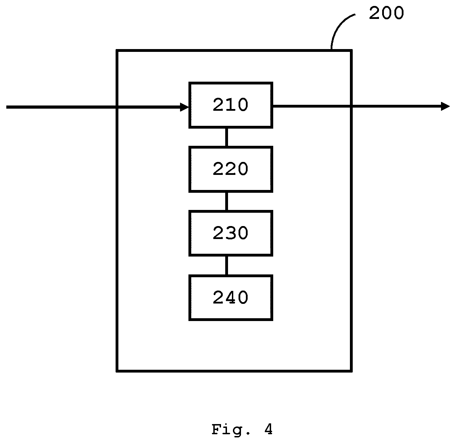

Fig. 4 show a schematic illustration of a hardware structure of an energy storage management device 200 comprising means for carrying out the steps of the methods of any of the embodiments disclosed above. The energy storage management device 200 has an interface module 210 configured to transmit and/or receive information (e.g. measurements of a temperature of the energy storage unit, an electrical current supplied from or to the energy storage unit and a terminal voltage of the energy storage unit by corresponding measurement devices). The energy storage management device 200 also has a processor 220 (e.g. a CPU) for controlling the energy storage management device 200 and for executing the steps of the methods of any of the embodiments disclosed above. It also has a working memory 230 (e.g. a random-access memory) and an instruction storage 240 storing a computer program having computer-readable instructions which, when executed by the processor 220, cause the processor 220 to perform the methods of any of the embodiments disclosed above.

The instruction storage 240 may include a ROM (e.g. in the form of an electrically erasable programmable read-only memory (EEPROM) or flash memory) which is pre-loaded with the computer-readable instructions. Alternatively, the instruction storage 240 may include a RAM or similar type of memory, and the computer-readable instructions can be input thereto from a computer program product, such as a computer-readable storage medium such as a CD-ROM, etc.

An energy storage unit and an energy storage management device according to any of the embodiments disclosed above may be integrated to form a system. The system may further comprise a system controller configured to transmit, to the energy storage management device, a desired remaining lifetime. In other words, the system controller may specify a target value for a remaining lifetime to be achieved by the energy storage unit. The energy storage management device may be configured to compute, based on this information, at least one of a target temperature range and a target SoC range required to reach the desired remaining lifetime. The energy storage management device may be configured to transmit, to the system controller, the at least one of the target SoC range and the target temperature range required to reach the desired remaining lifetime.

Alternatively, the system may be configured to transmit, to the energy storage management device, the desired remaining lifetime together with one of a desired SoC and a desired temperature. The energy storage management device may be configured to compute, based on this information, one of a target temperature range and a target SoC range, respectively, required to reach the desired remaining lifetime. The energy storage management device may be configured to transmit, to the system controller, the one of the target temperature range and the target SoC range required to reach the desired remaining lifetime and the one of the desired SoC and the desired temperature, respectively.

The system may further comprise a power converter configured to supply electrical current from or to the energy storage unit. In this case, the system controller may be configured to control the power converter to adjust an electrical current supplied from or to the energy storage unit based on the remaining lifetime such that the SoC is within a target SoC range associated with a desired remaining lifetime. As an example, the power converter may be controlled such that the energy storage unit is charged or discharged to a value of the SoC within the target SoC range.

Alternatively or in addition thereto, the system may further comprise a temperature regulation device configured to heat and/or cool the energy storage unit. In this case, the system controller may be configured to control the temperature regulation device to heat or cool the energy storage unit based on the remaining lifetime such that the temperature of the energy storage unit is within a target temperature range associated with a desired remaining lifetime. The temperature regulation device may be a fan, an air conditioner, a heater, a water-cooling system, or the like. The temperature regulation device may transfer heat to or away from the energy storage unit, thereby reducing or increasing its temperature to be within the target temperature range.

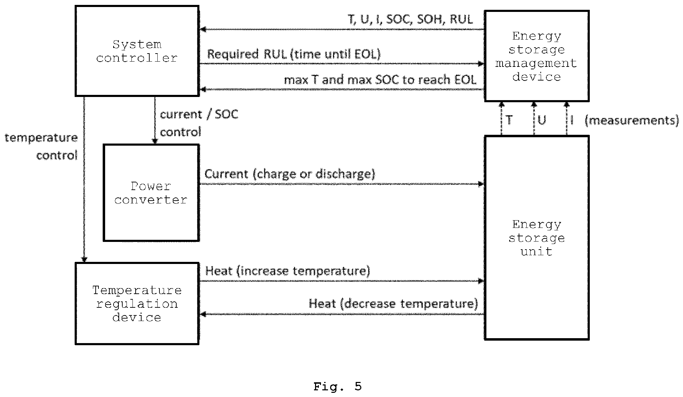

Fig. 5 shows a system according to an embodiment. Beside an energy storage unit and an energy storage management device, the system further comprises a system controller, a power converter, and a temperature regulation device.

In the foregoing description, aspects are described with reference to several embodiments. Accordingly, the specification should be regarded as illustrative, rather than restrictive. Similarly, the figures illustrated in the drawings, which highlight the functionality and advantages of the embodiments, are presented for example purposes only. The architecture of the embodiments is sufficiently flexible and configurable, such that it may be utilized in ways other than those shown in the accompanying figures.

Software embodiments presented herein may be provided as a computer program, or software, such as one or more programs having instructions or sequences of instructions, included or stored in an article of manufacture such as a machine-accessible or machine-readable medium, an instruction store, or computer-readable storage device, each of

## EP 4 571 335 B1

which can be non-transitory, in one example embodiment. The program or instructions on the non-transitory machine-accessible medium, machine-readable medium, instruction store, or computer-readable storage device, may be used to program a computer system or other electronic device. The machine- or computer-readable medium, instruction store, and storage device may include, but are not limited to, floppy diskettes, optical disks, and magneto-optical disks or other types of media/machine-readable medium/instruction store/storage device suitable for storing or transmitting electronic instructions. The techniques described herein are not limited to any particular software configuration. They may find applicability in any computing or processing environment. The terms "computer-readable", "machine-accessible medium", "machine-readable medium", "instruction store", and "computer-readable storage device" used herein shall include any medium that is capable of storing, encoding, or transmitting instructions or a sequence of instructions for execution by the machine, computer, or computer processor and that causes the machine/computer/computer processor to perform any one of the methods described herein. Furthermore, it is common in the art to speak of software, in one form or another (e.g., program, procedure, process, application, module, unit, logic, and so on), as taking an action or causing a result. Such expressions are merely a shorthand way of stating that the execution of the software by a processing system causes the processor to perform an action to produce a result.

Some embodiments may also be implemented by the preparation of application-specific integrated circuits, field-programmable gate arrays, or by interconnecting an appropriate network of conventional component circuits.

Some embodiments include a computer program product. The computer program product may be a storage medium or media, instruction store(s), or storage device(s), having instructions stored thereon or therein which can be used to control, or cause, a computer or computer processor to perform any of the procedures of the example embodiments described herein. The storage medium/instruction store/storage device may include, by example and without limitation, an optical disc, a ROM, a RAM, an EPROM, an EEPROM, a DRAM, a VRAM, a flash memory, a flash card, a magnetic card, an optical card, nano systems, a molecular memory integrated circuit, a RAID, remote data storage/archive/warehousing, and/or any other type of device suitable for storing instructions and/or data.

Stored on any one of the computer-readable medium or media, instruction store(s), or storage device(s), some implementations include software for controlling both the hardware of the system and for enabling the system or microprocessor to interact with a human user or other mechanism utilizing the results of the embodiments described herein. Such software may include without limitation device drivers, operating systems, and user applications. Ultimately, such computer-readable media or storage device (s) further include software for performing example aspects, as described above.

Included in the programming and/or software of the system are software modules for implementing the procedures described herein. In some example embodiments herein, a module includes software, although in other example embodiments herein, a module includes hardware, or a combination of hardware and software.

While various embodiments of the present disclosure have been described above, it should be understood that they have been presented by way of example, and not limitation. It will be apparent to persons skilled in the relevant art(s) that various changes in form and detail can be made therein. Thus, the above-described example embodiments are not limiting.

REFERENCES

[1]: CN102216794A
[2]: WO2022248532A1
[3]: CN100514074C
[4]: EP3092144B1
[5]: CN108919137B
[6]: EP application 23 182 613.2

## Claims

1. A computer-implemented method (1000) for determining a remaining lifetime of an energy storage unit, the method comprising:

 acquiring (S1100) a temperature of the energy storage unit, an electrical current supplied from or to the energy storage unit and a terminal voltage of the energy storage unit;
 estimating (S1200) a state of charge, SoC, and a present value of an energy storage parameter of the energy storage unit based on the temperature, the electrical current and the terminal voltage;

deriving (S1300) an aging model of the energy storage unit based on the SoC and the temperature, wherein the aging model is indicative of a predicted time evolution of the energy storage parameter of the energy storage unit; and

determining (S1400) the remaining lifetime based on the derived aging model, the present value of the energy storage parameter and an initial value of the energy storage parameter;

wherein the method (1000) further comprises at least one of:

adjusting an electrical current supplied to the energy storage unit based on the remaining lifetime such that the SoC of the energy storage unit is within a target SoC range associated with a desired remaining lifetime;

adjusting an electrical current supplied to the energy storage unit based on the remaining lifetime such that the temperature of the energy storage unit is within a target temperature range associated with a desired remaining lifetime; and

controlling a temperature regulation device to heat or cool the energy storage unit based on the remaining lifetime such that the temperature of the energy storage unit is within a target temperature range associated with a desired remaining lifetime.

2. The method (1000) according to claim 1, wherein

acquiring the temperature, electrical current and terminal voltage, and estimating the SoC are performed for multiple points in time, and

the aging model is derived based on the SoC and the temperature at one or more of the multiple points in time.

3. The method (1000) according to any one of claims 1 or 2, wherein the aging model is derived based on the SoC and the temperature at a present point in time of the multiple points in time.

4. The method (1000) according to any one of claims 1 or 2, wherein the aging model is derived based on an average SoC and an average temperature over two or more of the multiple points in time.

5. The method (1000) according to any one of claims 1 to 4, wherein the aging model is based on an aging factor having a functional dependency on the SoC and the temperature of the energy storage unit.

6. The method (1000) according to claim 5, wherein parameters in the functional dependency are determined by a regression based on a plurality of measurement points.

7. The method (1000) according to claim 6, wherein each of the plurality of measurement points comprises a reference aging parameter associated with a given combination of SoC and temperature, wherein the reference aging parameter is derived based on a measured time evolution of the energy storage parameter of a corresponding reference energy storage unit.

8. The method (1000) according to any one of claims 1 to 7, wherein the energy storage unit is a supercapacitor.

9. The method (1000) according to any one of claims 1 to 7, wherein the energy storage unit is a battery.

10. The method (1000) according to any one of claims 1 to 9, further comprising at least one of:

outputting, on a graphical user interface, the remaining lifetime of the energy storage unit;

scheduling replacement of the energy storage unit based on the remaining lifetime.

11. An energy storage management device configured to perform the method (1000) according to any one of claims 1 to 10.

12. A system comprising:

an energy storage unit; and

an energy storage management device according to claim 11.

13. The system according to claim 12, further comprising:

a system controller configured to transmit, to the energy storage management device, a desired remaining lifetime; and

wherein the energy storage management device is configured to transmit, to the system controller, at least one of a target SoC range and a target temperature range required to reach the desired remaining lifetime.

14. The system according to claim 13, further comprising:

a power converter configured to supply electrical current from or to the energy storage unit; and

wherein the system controller is configured to control the power converter to adjust an electrical current supplied from or to the energy storage unit based on the remaining lifetime such that the SoC is within the target SoC range associated with a desired remaining lifetime.

15. The system according to any one of claims 13 or 14, further comprising:

a temperature regulation device configured to heat and/or cool the energy storage unit; and

wherein the system controller is configured to control the temperature regulation device to heat or cool the energy storage unit based on the remaining lifetime such that the temperature of the energy storage unit is within the target temperature range associated with a desired remaining lifetime.

**Patentansprüche**

1. Computerimplementiertes Verfahren (1000) zum Bestimmen der Restlebensdauer einer Energiespeichereinheit, wobei das Verfahren Folgendes umfasst:

Erfassen (S1100) einer Temperatur der Energiespeichereinheit, eines von der oder an die Energiespeichereinheit zugeführten elektrischen Stroms und einer Anschlussspannung der Energiespeichereinheit;

Schätzen (S1200) eines Ladezustands, SoC, und eines aktuellen Werts eines Energiespeicherparameters der Energiespeichereinheit, basierend auf der Temperatur, dem elektrischen Strom und der Anschlussspannung;

Ableiten (S1300) eines Alterungsmodells der Energiespeichereinheit, basierend auf dem SoC und der Temperatur, wobei das Alterungsmodell eine vorhergesagte Zeitentwicklung des Energiespeicherparameters der Energiespeichereinheit angibt; und

Bestimmen (S1400) der Restlebensdauer, basierend auf dem abgeleiteten Alterungsmodell, dem aktuellen Wert des Energiespeicherparameters und einem Anfangswert des Energiespeicherparameters;

wobei das Verfahren (1000) weiter mindestens eines aus Folgendem umfasst:

Anpassen eines der Energiespeichereinheit zugeführten elektrischen Stroms, basierend auf der Restlebensdauer, so dass der SoC der Energiespeichereinheit innerhalb eines Ziel-SoC-Bereichs ist, der mit einer gewünschten Restlebensdauer assoziiert ist;

Anpassen eines der Energiespeichereinheit zugeführten elektrischen Stroms, basierend auf der Restlebensdauer, so dass die Temperatur der Energiespeichereinheit innerhalb eines Ziel-Temperaturbereichs ist, der mit einer gewünschten Restlebensdauer assoziiert ist; und

Steuern einer Temperaturregelungsvorrichtung zum Wärmen oder Kühlen der Energiespeichereinheit, basierend auf der Restlebensdauer, so dass die Temperatur der Energiespeichereinheit innerhalb eines Ziel-Temperaturbereichs ist, der mit einer gewünschten Restlebensdauer assoziiert ist.

2. Verfahren (1000) nach Anspruch 1, wobei

Erfassen der Temperatur, des elektrischen Stroms und der Anschlussspannung und Schätzen des SoC für mehrere Zeitpunkte durchgeführt werden, und

das Alterungsmodell, basierend auf dem SoC und der Temperatur zu einem oder mehreren der mehreren Zeitpunkte, abgeleitet wird.

3. Verfahren (1000) nach einem der Ansprüche 1 oder 2, wobei das Alterungsmodell, basierend auf dem SoC und der Temperatur zu einem aktuellen Zeitpunkt der mehreren Zeitpunkte, abgeleitet wird.

4. Verfahren (1000) nach einem der Ansprüche 1 oder 2, wobei das Alterungsmodell, basierend auf einem durchschnittlichen SoC und einer durchschnittlichen Temperatur über zwei oder mehr der mehreren Zeitpunkte, abgeleitet wird.

5. Verfahren (1000) nach einem der Ansprüche 1 bis 4, wobei das Alterungsmodell auf einem Alterungsfaktor basiert, der eine funktionale Abhängigkeit vom SoC und der Temperatur der Energiespeichereinheit aufweist.

6. Verfahren (1000) nach Anspruch 5, wobei Parameter in der funktionalen Abhängigkeit durch eine Regression, basierend auf einer Vielzahl von Messpunkten, bestimmt werden.

7. Verfahren (1000) nach Anspruch 6, wobei jeder der Vielzahl von Messpunkten einen Referenzalterungsparameter umfasst, der mit einer gegebenen Kombination aus SoC und Temperatur assoziiert ist, wobei der Referenzalterungsparameter, basierend auf einer gemessenen zeitlichen Entwicklung des Energiespeicherparameters einer entsprechenden Referenzenergiespeichereinheit, abgeleitet wird.

8. Verfahren (1000) nach einem der Ansprüche 1 bis 7, wobei die Energiespeichereinheit ein Superkondensator ist.

9. Verfahren (1000) nach einem der Ansprüche 1 bis 7, wobei die Energiespeichereinheit eine Batterie ist.

10. Verfahren (1000) nach einem der Ansprüche 1 bis 9, weiter umfassend mindestens eines aus Folgendem:

Ausgeben, auf einer grafischen Benutzeroberfläche, der Restlebensdauer der Energiespeichereinheit;
Planen des Austauschs der Energiespeichereinheit, basierend auf der Restlebensdauer.

11. Energiespeicherverwaltungsvorrichtung, die ausgebildet ist, um das Verfahren (1000) nach einem der Ansprüche 1 bis 10 durchzuführen.

12. System, umfassend:

eine Energiespeichereinheit; und
eine Energiespeicherverwaltungsvorrichtung nach Anspruch 11.

13. System nach Anspruch 12, weiter umfassend:

eine Systemsteuereinheit, die ausgebildet ist, um eine gewünschte Restlebensdauer an die Energiespeicherverwaltungsvorrichtung zu übertragen; und
wobei die Energiespeicherverwaltungsvorrichtung ausgebildet ist, um mindestens einen aus einem Ziel-SoC-Bereich und einem Ziel-Temperaturbereich, die erforderlich sind, um die gewünschte Restlebensdauer zu erreichen, an die Systemsteuereinheit zu übertragen.

14. System nach Anspruch 13, weiter umfassend:

einen Stromrichter, der ausgebildet ist, um elektrischen Strom von der oder an die Energiespeichereinheit zuzuführen; und
wobei die Systemsteuereinheit ausgebildet ist, um den Stromrichter zu steuern, um den von der oder an die Energiespeichereinheit zugeführten elektrischen Strom, basierend auf der Restlebensdauer, anzupassen, so dass der SoC innerhalb des Ziel-SoC-Bereichs ist, der mit einer gewünschten Restlebensdauer assoziiert ist.

15. System nach einem der Ansprüche 13 oder 14, weiter umfassend:

eine Temperaturregelungsvorrichtung, die ausgebildet ist, um die Energiespeichereinheit zu wärmen und/oder zu kühlen; und
wobei die Systemsteuereinheit ausgebildet ist, um die Temperaturregelungsvorrichtung zu steuern, um die Energiespeichereinheit, basierend auf der Restlebensdauer, zu wärmen oder zu kühlen, so dass die Temperatur der Energiespeichereinheit innerhalb des Ziel-Temperaturbereichs ist, der mit einer gewünschten Restlebensdauer assoziiert ist.

**Revendications**

1. Procédé (1000) mis en œuvre par ordinateur pour déterminer une durée de vie restante d'une unité de stockage d'énergie, le procédé comprenant :

   l'acquisition (S1100) d'une température de l'unité de stockage d'énergie, d'un courant électrique fourni depuis ou vers l'unité de stockage d'énergie et d'une tension aux bornes de l'unité de stockage d'énergie ;
   l'estimation (S1200) d'un état de charge, SoC, et d'une présente valeur d'un paramètre de stockage d'énergie de l'unité de stockage d'énergie sur la base de la température, du courant électrique et de la tension aux bornes ;
   la dérivation (S1300) d'un modèle de vieillissement de l'unité de stockage d'énergie sur la base du SoC et de la température, dans lequel le modèle de vieillissement est indicatif d'une évolution temporelle prédite du paramètre de stockage d'énergie de l'unité de stockage d'énergie ; et
   la détermination (S1400) de la durée de vie restante sur la base du modèle de vieillissement dérivé, de la présente valeur du paramètre de stockage d'énergie et d'une valeur initiale du paramètre de stockage d'énergie ;
   dans lequel le procédé (1000) comprend en outre au moins une opération parmi :

   l'ajustement d'un courant électrique fourni à l'unité de stockage d'énergie sur la base de la durée de vie restante de telle sorte que le SoC de l'unité de stockage d'énergie se situe dans une plage de SoC cible associée à une durée de vie restante souhaitée ;
   l'ajustement un courant électrique fourni à l'unité de stockage d'énergie sur la base de la durée de vie restante de telle sorte que la température de l'unité de stockage d'énergie se situe dans une plage de température cible associée à une durée de vie restante souhaitée ; et
   la commande d'un dispositif de régulation de température pour chauffer ou refroidir l'unité de stockage d'énergie sur la base de la durée de vie restante de telle sorte que la température de l'unité de stockage d'énergie se situe dans une plage de température cible associée à une durée de vie restante souhaitée.

2. Procédé (1000) selon la revendication 1, dans lequel

   l'acquisition de la température, du courant électrique et de la tension aux bornes, et l'estimation du SoC sont effectuées pour de multiples points dans le temps, et
   le modèle de vieillissement est dérivé sur la base du SoC et de la température à un ou plusieurs des multiples points dans le temps.

3. Procédé (1000) selon l'une quelconque de la revendication 1 ou la revendication 2, dans lequel le modèle de vieillissement est dérivé sur la base du SoC et de la température à un point présent dans le temps parmi les multiples points dans le temps.

4. Procédé (1000) selon l'une quelconque de la revendication 1 ou la revendication 2, dans lequel le modèle de vieillissement est dérivé sur la base d'un SoC moyen et d'une température moyenne sur deux ou plus des multiples points dans le temps.

5. Procédé (1000) selon l'une quelconque des revendications 1 à 4, dans lequel le modèle de vieillissement est basé sur un facteur de vieillissement présentant une dépendance fonctionnelle sur le SoC et sur la température de l'unité de stockage d'énergie.

6. Procédé (1000) selon la revendication 5, dans lequel des paramètres dans la dépendance fonctionnelle sont déterminés par une régression basée sur une pluralité de points de mesure.

7. Procédé (1000) selon la revendication 6, dans lequel chacun de la pluralité de points de mesure comprend un paramètre de vieillissement de référence associé à une combinaison donnée de SoC et de température, dans lequel le paramètre de vieillissement de référence est dérivé sur la base d'une évolution temporelle mesurée du paramètre de stockage d'énergie d'une unité de stockage d'énergie de référence correspondante.

8. Procédé (1000) selon l'une quelconque des revendications 1 à 7, dans lequel l'unité de stockage d'énergie est un super-condensateur.

9. Procédé (1000) selon l'une quelconque des revendications 1 à 7, dans lequel l'unité de stockage d'énergie est une batterie.

**10.** Procédé (1000) selon l'une quelconque des revendications 1 à 9, comprenant en outre au moins une opération parmi :

la sortie, sur une interface utilisateur graphique, de la durée de vie restante de l'unité de stockage d'énergie ;
la planification du remplacement de l'unité de stockage d'énergie sur la base de la durée de vie restante.

**11.** Dispositif de gestion de stockage d'énergie configuré pour effectuer le procédé (1000) selon l'une quelconque des revendications 1 à 10.

**12.** Système comprenant :

une unité de stockage d'énergie ; et
un dispositif de gestion de stockage d'énergie selon la revendication 11.

**13.** Système selon la revendication 12, comprenant en outre :

un dispositif de commande système configuré pour transmettre, au dispositif de gestion de stockage d'énergie, une durée de vie restante souhaitée ; et
dans lequel le dispositif de gestion de stockage d'énergie est configuré pour transmettre, au dispositif de commande système, au moins une parmi une plage de SoC cible et une plage de température cible requises pour atteindre la durée de vie restante souhaitée.

**14.** Système selon la revendication 13, comprenant en outre :

un convertisseur de puissance configuré pour fournir un courant électrique depuis ou vers l'unité de stockage d'énergie ; et
dans lequel le dispositif de commande système est configuré pour commander le convertisseur de puissance afin d'ajuster un courant électrique fourni depuis ou vers l'unité de stockage d'énergie sur la base de la durée de vie restante de telle sorte que le SoC se situe dans la plage de SoC cible associée à une durée de vie restante souhaitée.

**15.** Système selon l'une quelconque de la revendication 13 ou la revendication 14, comprenant en outre :

un dispositif de régulation de température configuré pour chauffer et/ou refroidir l'unité de stockage d'énergie ; et
dans lequel le dispositif de commande système est configuré pour commander le dispositif de régulation de température afin de chauffer ou de refroidir l'unité de stockage d'énergie sur la base de la durée de vie restante de telle sorte que la température de l'unité de stockage d'énergie se situe dans la plage de température cible associée à une durée de vie restante souhaitée.

1000

START

Acquiring temperature, electrical current, and a
terminal voltage of the energy storage unit

S1100

Estimating SoC and present value of energy storage
parameter

S1200

Deriving aging model of the energy storage unit
indicative of predicted time evolution of energy
storage parameter

S1300

Determining remaining lifetime

S1400

END

Fig. 1

Fig. 2

Fig. 3A

| Parameter | Value |
|---|---|
| p | $4.9347 \times 10^{-7}$ |
| q | $1.5759 \times 10^{-6}$ |
| r | $3.3722 \times 10^{-6}$ |
| A | 1.20229 |
| $T_{ref}$ | 65 |
| $\Delta T$ | 11.4265 |

Fig. 3B

Fig. 4

Fig. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2023278463 A1
- CN 102216794 A
- WO 2022248532 A1
- CN 100514074 C
- EP 3092144 B1
- CN 108919137 B
- EP 23182613 A

**Non-patent literature cited in the description**

- Advanced Model of Hybrid Energy Storage System Integrating Lithium-Ion Battery and Supercapacitor for Electric Vehicle Applications. **MESBAHI TEDJANI et al.** IEEE TRANSACTIONS ON INDUSTRIAL ELECTRONICS. IEEE SERVICE CENTER, 15 April 2020, vol. 68, 3962-3972